# EUROPÄISCHE PATENTANMELDUNG

(11) **EP 0 984 490 A1**
(43) Veröffentlichungstag der Anmeldung: **08.03.2000**
(21) Anmeldenummer: 99115427.9
(22) Anmeldetag: 04.08.1999
(51) Int. Cl.: H01L 21/8242, H01L 21/311, H01L 21/02, H01L 27/108, H01L 29/92

(54) **Verfahren zur Erzeugung strukturierter Materialschichten**

(30) Priorität: 13.08.1998 DE 19836751
(71) Anmelder: SIEMENS AKTIENGESELLSCHAFT, 80333 München (DE)
(72) Erfinder: Schindler, Günther, Dr., 80802 München (DE); Hartner, Walter, 81829 München (DE)

(57) **Zusammenfassung**

Beschrieben wird ein Verfahren zur Erzeugung strukturierter Materialschichten (3, 8) auf einem Grundkörper (2), insbesondere einem Halbleiterkörper, mit den Schritten
- Bereitstellen einer ersten Materialschicht (3)
- Strukturieren der ersten Materialschicht (3) durch teilweisen oder vollständigen lokalen Schichtabtrag zur Bildung erhabener (4) und vertiefter Schichtgebiete
- Aufbringen einer weiteren Materialschicht (8).
Dabei wird die strukturierte erste Materialschicht (3) als permanent verbleibende Materialschicht vorgesehen, und durch die Höhendifferenz an den Kanten der strukturierten ersten Materialschicht (3), die durch Übergänge von erhabenen (4) zu vertieften Schichtgebieten gebildet werden, erfolgt eine Trennung einzelner Schichtgebiete der weiteren Materialschicht (8) an den Kanten, wobei die Kanten der erhabenen Gebiete (4) als Abrißkanten der weiteren Materialschicht (8) wirken.

## Beschreibung

Die Erfindung betrifft ein Verfahren zur Erzeugung strukturierter Materialschichten. Solche Materialschichten finden in der Halbleitertechnologie Anwendung und werden üblicherweise mit Hilfe lithographischer Verfahren hergestellt, wobei in der Regel zunächst ein strahlungsempfindlicher Lack strukturiert wird und anschließend die Struktur in einem Ätzschritt in darunterliegende Materialschichten übertragen wird. Im einzelnen werden dabei folgende Schritte durchgeführt:
- Aufbringen eines strahlungsempfindlichen Lacks auf die zu strukturierende Materialschicht
- Bestrahlung des Lacks unter Verwendung einer Maske für die gewünschte Struktur
- Entwickeln der Lackschicht zur Erzeugung einer Lackstruktur
- Herausätzen der zu strukturierenden Materialschicht an den geöffneten Stellen, die nicht von der entwickelten Lack schicht bedeckt sind
- Ablösung der verbleibenden Lackschicht.
Es sind jedoch nicht alle Materialschichten einer Strukturierung durch solche Verfahren zugänglich. Dies gilt insbesondere, wenn es sich dabei um kaum ätzbare Materialschichten, z.B. Edelmetalle wie Au, Pt oder Platinmetalle wie Ir oder Pd sowie diverse Oxidmaterialien wie IrO₂ oder magnetische Materialien handelt. In diesen Fällen ist eine Strukturierung der Materialschichten kaum möglich oder es bilden sich bei dem Prozeß nur sehr flache Flanken der Strukturen oder gar Fehlstrukturierungen wie unerwünschte Ablagerungen. In einem solchen Fall wird auf indirekte Strukturierungsverfahren wie das sogenannte 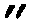 Lift-Off-Verfahren" zurückgegriffen:
- Bereitstellen einer ersten Materialschicht
- Strukturieren der ersten Materialschicht
- Aufbringen mindestens einer weiteren Materialschicht
- Entfernen der verbleibenden Teile der ersten Materialschicht, wobei an diesen Stellen die auf der ersten Materialschicht aufgebrachten Teile der mindestens einen weiteren Materialschicht automatisch mit entfernt werden. Es bleibt eine strukturierte zweite Materialschicht übrig. Problematisch hierbei ist jedoch die stark eingeschränkte Tauglichkeit des Verfahrens zur Erzeugung kleiner Strukturen, besonders im Sub-µm-Bereich, sowie die schwere produktionstechnische Handhabung des Verfahrens. Auch wird das Material der weiteren Materialschicht beim Entfernen zusammen mit der ersten Schicht zum Teil in unerwünschter Weise wieder abgeschieden.

Auf dem Gebiet der Halbleitertechnologie werden diese Verfahren dazu verwendet, um einzelne Bauelemente wie Transistoren, Kondensatoren etc. zu erzeugen. Nachteilig an den vorgenannten Verfahren ist jedoch, daß neben den genannten Problemen jeweils ein langwieriges Verfahren aus Auf- und Abtrag von Schichten notwendig ist, wobei gerade bei den Abtragungsschritten hohe Anforderungen an die Selektivität des Schichtabtrages einzuhalten sind, um nur die gewünschte Schicht abzutragen. Zudem ist das lithographische Verfahren nur bedingt anwendbar und versagt bei einer Reihe von Materialien. Diese Nachteile können somit zu hohen Produktionskosten in der Bauelementefertigung führen.
Es besteht schließlich die Möglichkeit der direkten Strukturierung einer Materialschicht, welche keinem lithographischen Verfahren zugänglich ist, indem ein Schichtabtrag durch Beschuß mit Ionen bzw. Plasmaätzung erfolgt. Hierbei ergeben sich jedoch die Schwierigkeiten, daß der Abtragsprozeß nur langsam abläuft, lediglich Seitenflanken geringer Steilheit gebildet werden können und Fehlstrukturierungen durch Wiederabscheidung des abgetragenen Schichtmaterials entstehen können.

Zu Einzelheiten der genannten Strukturierungsverfahren wird auf aktuelle Standardliteratur zur Halbleitertechnologie verwiesen wie beispielsweise D. Widmann, H. Mader, H. Friedrich: Technologie hochintegrierter Schaltungen, 2. Auflage, Springer-Verlag Berlin 1996, S. 29, 101 - 102 und 166 - 168.

Aufgabe der vorliegenden Erfindung ist es daher, ein Verfahren bereitzustellen, das eine vereinfachte Möglichkeit zur Erzeugung strukturierter Materialschichten bietet.
Diese Aufgabe wird erfindungsgemäß gelöst durch die Merkmale des Anspruchs 1.
Besonders vorteilhaft ist dabei, daß die erste Schicht nach ihrer Strukturierung permanent auf dem Grundkörper verbleibt und somit kein Abtragen dieser strukturierten Schicht mehr nötig ist. Als erste Schicht kann dabei bereits die Substratschicht verwendet werden. Idealerweise wird als erste Schicht ein Material gewählt, das eine relativ leichte Strukturierung erlaubt. Die Strukturierung der mindestens einen weiteren Schicht in einzelne Bereiche ergibt sich dann automatisch durch die Höhenunterschiede der Oberflächenformgebung der ersten Schicht, wobei lediglich zu beachten ist, daß die Schichtdicke der weiteren Materialschicht zumindest geringer sein muß als der Höhenunterschied an den Kanten, die durch aneinander angrenzende erhabene und vertiefte Gebiete gebildet werden. Idealerweise beträgt die Höhendifferenz zwischen erhabenen und vertieften Schichtgebieten mindestens das 2-fache der Schichtdicke der weiteren Materialschicht, bevorzugt das 2 bis 5-fache der Schichtdicke. Diese Kanten wirken dann als Abrißkanten, die für eine Trennung der erhabenen Gebiete der weiteren Materialschicht von den vertieften Gebieten dieser Materialschicht im Bereich der Kanten sorgen. Mit dieser Methode ist gerade die Erzeugung kleiner Strukturen in der zu strukturierenden Materialschicht leicher möglich als mit Verfahren, die einen lokalen Abtrag der Materialschicht erfordern und damit zwangsläufig größere Ungenauigkeiten bei der Strukturierung der Materialschicht mit sich bringen.

Bevorzugt wird die erste weitere Materialschicht durch ein Auftragungsverfahren mit gerichteter Abscheidungscharakteristik, beispielsweise durch kollimiertes Sputtern, auf der Oberfläche der ersten Materialschicht abgeschieden, d.h. durch eine Auftragung, die idealerweise nur senkrecht zur Schichtebene erfolgt. Eine Beschichtung der Flanken der Erhebungen und Vertiefungen der zu beschichtenden Oberfläche wird damit vermieden und man erhält eine klare Trennung einzelner Bereiche der Materialschicht.

Eine klare Trennung der einzelnen Schichtgebiete im Bereich der Kanten kann alternativ oder zusätzlich erzielt werden, wenn nach dem Abscheiden der mindestens einen weiteren Materialschicht ein geeigneter Schichtabtrag der mindestens einen weiteren Materialschicht - wie z.B. ein Ätzschritt - zur Entfernung von Kantenbedeckungen durchgeführt wird. Der Schichtabtrag kann nun jedoch mit wesentlich geringen Anforderungen an Selektivität, Kantensteilheit oder Abtragsgeschwindigkeit ausfallen, als dies z.B. bei einer direkten Strukturierung der weiteren Materialschichten der Fall wäre.

Es kann auch eine Hilfsschicht auf den Erhebungen vorgesehen werden, die vor der Abscheidung der mindestens einen weiteren Materialschicht derart chemisch verändert wird, daß eine Volumenausdehnung dieser Hilfsschicht erfolgt. Damit ragt diese Hilfsschicht über die Kanten der Erhebungen der ersten Materialschicht hinaus und schattet so die Seitenflanken der Erhebungen ab. Dies ist insbesondere dann vorteilhaft, wenn keine optimale Steilheit der Seitenflanken erzielt werden kann, die Seitenflanken also nicht ideal senkrecht zur Schichtoberfläche strukturiert werden können. Als chemische Veränderung der Hilfsschicht ist z.B. eine Oxidation oder eine Nitrierung möglich. So können als chemisch veränderte Hilfsschichten beispielsweise SiO₂, Si₃N₄, TiOₓ oder TaOₓ erzeugt werden.

In einer bevorzugten Ausführungsform ist vorgesehen, daß die Erhebungen der ersten Materialschicht die funktional aktiven Bereiche der mindestens einen weiteren Materialschicht definieren. Dabei kann es sinnvoll sein, eine Abdeckung der abgesenkten Bereiche der mindestens einen weiteren Materialschicht durchzuführen, die geeignet ist, diese Bereiche funktional zu neutralisieren. Damit werden diese nicht benötigten Bereiche einer Materialschicht auf relativ unkomplizierte Weise neutralisiert und noch weitgehender von den funktional aktiven Bereichen isoliert. Je nach Eigenschaft der nächsten Materialschichten kann diese Abdeckung bereits durch diese nächsten Schichten selbst erfolgen. Hierzu bietet sich an, daß nach der Auftragung der ersten weiteren Materialschicht eine konformale Auftragung mindestens noch einer weiteren Materialschicht erfolgt, d.h. diese weitere Materialschicht wird mit im wesentlichen gleichbleibender Schichtdicke auf der gesamten Oberfläche aufgetragen. Es kann jedoch auch eine gerichtete Abscheidung der weiteren Materialschichten vorgesehen werden.

Das beschriebene Verfahren läßt sich zur Herstellung von integrierten Schaltkreisen wie z.B. Speicheranordnungen verwenden, wobei durch die Strukturierung der Materialschichten die Bauelemente der integrierten Schaltkreise erzeugt werden.

Speziell die Speicheranordnungen zeichnen sich dadurch aus, daß in einen Halbleiterkörper sowie eine auf den Halbleiterkörper aufgebrachte Isolationsschicht Auswahltransistoren eingebettet werden und auf einer Trägerschicht elektrische Bauelemente, insbesondere Speicherkondensatoren, angeordnet werden, indem weitere Materialschichten zur Erzeugung der Bauelemente auf der Oberfläche der Trägerschicht abgeschieden werden. Dabei kann als Trägerschicht auch die Isolationsschicht verwendet werden, in die die Auswahltransistoren eingebettet sind. Eine Strukturierung der Materialschichten, aus denen die Bauelemente aufgebaut werden, kann nun entsprechend dem erfindungsgemäßen Gedanken auf einfache Weise durch eine Strukturierung der Oberfläche der Trägerschicht in erhabene und abgesenkte Gebiete erfolgt. Dabei können beispielsweise Erhebungen in der Trägerschicht bereits so strukturiert werden, daß sie Form und Lage eines Bauelements wie z.B. die eines Speicherkondensators direkt vorgeben. Das Bauelement, in diesem Fall der Speicherkondensator, entsteht dann automatisch durch die nachfolgenden Materialabscheidungen auf der Erhebung der Trägerschicht.
So wird zur Erzeugung von Speicherkondensatoren zunächst eine erste Elektrodenschicht für eine erste Kondensatorelektrode der Speicherkondensatoren durch ein Auftragungsverfahren mit gerichteter Abscheidungscharakteristik, z.B. eine kollimierte Abscheidung wie beispielsweise ein Sputter-Verfahren, auf der Oberfläche der Trägerschicht abgeschieden wird. Über dieser ersten Elektrodenschicht wird das Speicherdielektrikum sowie eine zweite Elektrodenschicht abgeschieden. Die Abscheidung dieser beiden Schichten kann sowohl durch eine konformale Abscheidung als auch durch eine kollimierte Auftragung erfolgen, wobei auch eine Kombination der beiden Auftragungsarten denkbar ist. Als Material für das Speicherdielektrikum können sowohl dielektrische als auch ferroelektrische Substanzen vorgesehen sein. Das Elektrodenmaterial ist an die gewünschte Funktion des Kondensators anzupassen, wobei auch die weiteren Prozeßparameter zur Fertigstellung der Speicheranordnung bei der Auswahl des Elektrodenmaterials wie auch der übrigen verwendeten Materialschichten zu berücksichtigen sind. So sind zur Herstellung von DRAM oder FRAM-Speicheranordnungen mit einem Dielektrikum mit hoher Dielektrizitätskonstante oder ferroelektrischem Dielektrikum als Speicherdielektrikum beispielsweise oxidische Dielektrika möglich wie SBT SrBi₂Ta₂O₉, SBTN SrBi₂(Ta₁₋ₓNbₓ)₂O₉, PZT PbₓZr₁₋ₓTiO₃ oder BST BaₓSr₁₋ₓTiO₃. Denkbar sind jedoch auch andere perovskitartige para- oder ferroelektrische Materialschichten. Da zur Herstellung solcher Speicherkondensatoren für DRAM oder FRAM-Speicheranordnungen relativ hohe Temperaturen bis 800°C nötig sind, müssen entsprechend geeignete Elektrodenmaterialien wie Edelmetalle oder deren Oxide wie z.B. Platin oder Platinmetalle wie Ru, Os, Rh, Ir oder Pd verwendet werden, um den hohen Anforderungen bei der Herstellung der Kondensatoren gerecht zu werden.

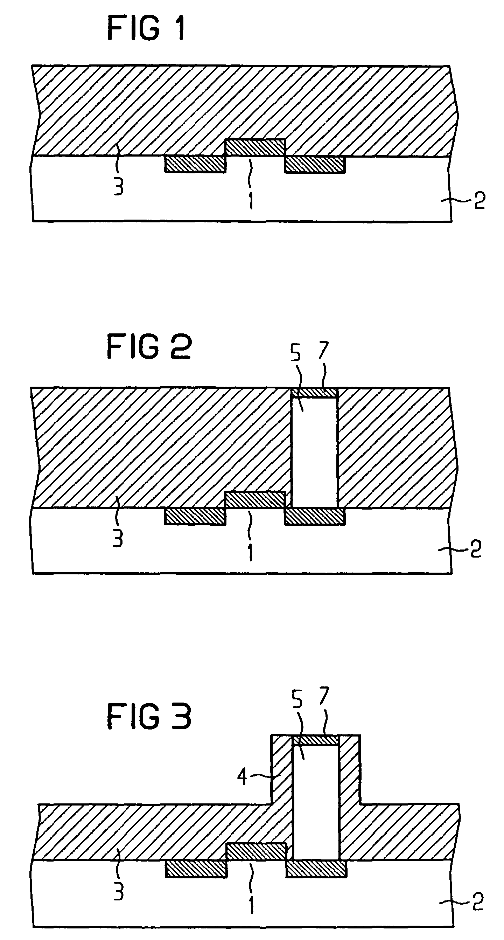

Ein spezielles Ausführungsbeispiel der Erfindung wird anhand der nachfolgenden Figuren 1 und 2 erläutert. Dabei wird die Herstellung einer Speicheranordnung erläutert, bestehend aus einer Anzahl Speicherzellen, die zumindest einen Auswahltransistor sowie einen Speicherkondensator aufweisen, der in leitender Verbindung mit dem Auswahltransistor steht. Dabei ist der Auswahltransistor in einen Halbleiterkörper sowie eine darauf angebrachte Isolationsschicht eingebettet. Weitere elektrische Bauelemente wie insbesondere Zuleitungen oder der Speicherkondensator der Speicherzelle werden auf der Isolationsschicht angeordnet.

Es zeigen:
- Fig. 1:: eine schematische Darstellung des Halbleiterkörpers und der Isolationsschicht mit den Auswahltransistoren
- Fig. 2:: Herstellung der Plugverbindung
- Fig. 3:: Strukturierung der Isolationsschicht
- Fig. 4:: kollimierte Aufbringung der ersten Materialschicht
- Fig. 5:: konformale Aufbringung der weiteren Schichten
- Fig. 6:: kollimierte Aufbringung der weiteren Schichten

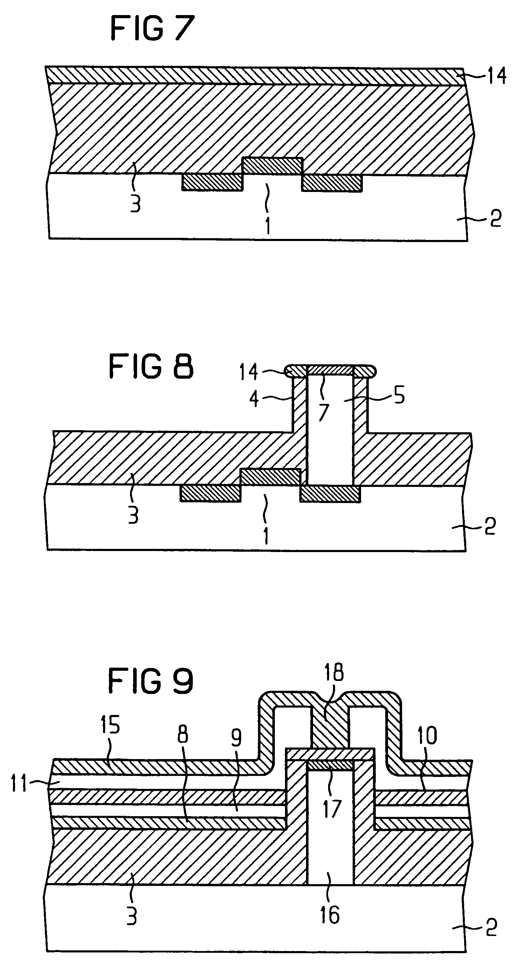

- Fig. 7:: Auftragung einer Hilfsschicht auf die Isolationsschicht
- Fig. 8:: chemisch veränderte Hilfsschicht nach Strukturierung zur Abschattung der Seitenflanken der Strukturen
- Fig. 9:: Kontaktierung der Substratschicht
- Fig. 10:: Isolationsschicht mit Hilfsschicht nach nichtselektiver Ätzung
- Fig. 11:: Isolationsschicht mit Hilfsschicht nach selektiver Ätzung der Isolationsschicht
- Fig. 12:: Isolationsschicht mit Hilfsschicht nach weitgehend kollimiertem Auftrag einer weiteren Materialschicht

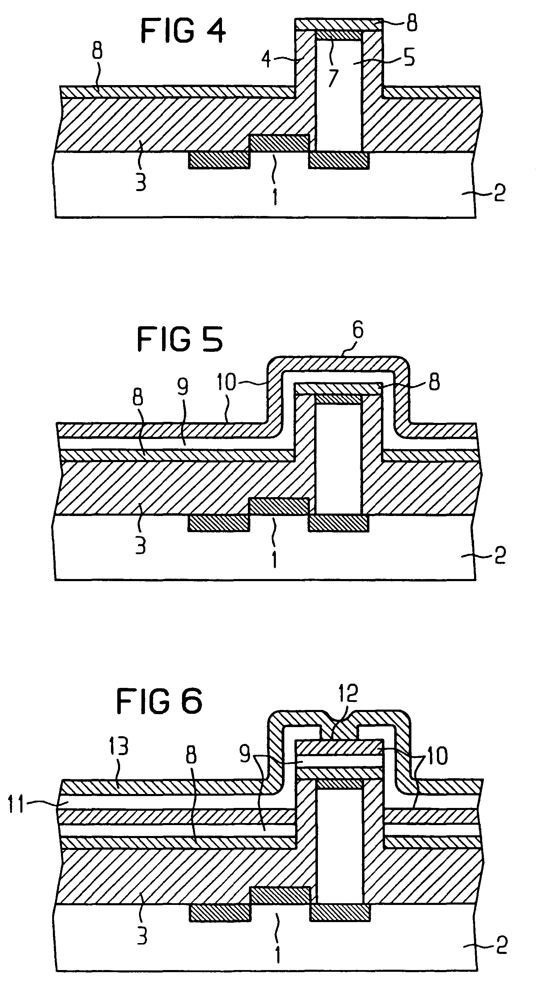

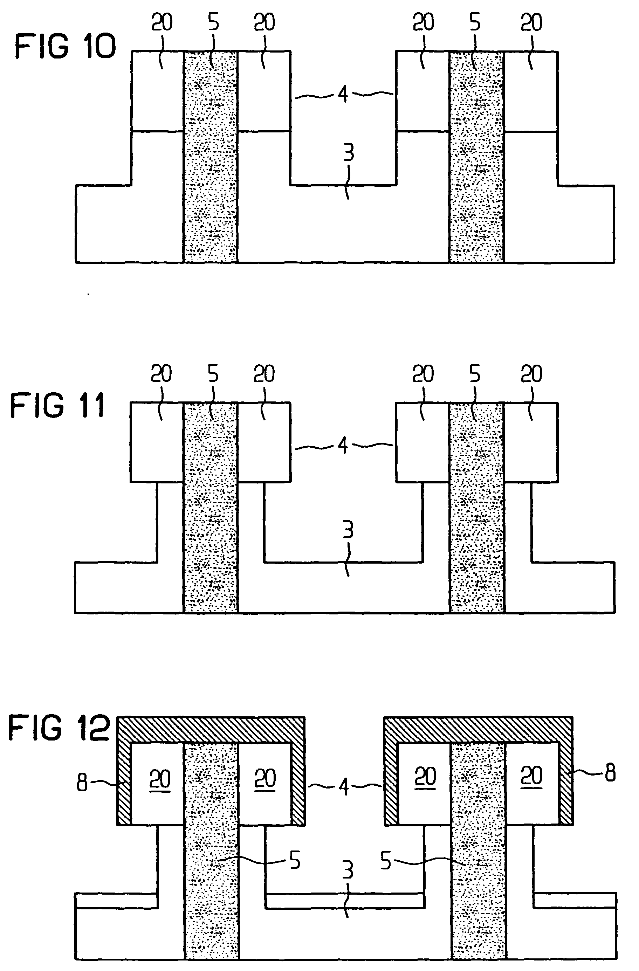

Betrachtet werden spezielle Speicherzellen, die in letzter Zeit, besonders zur Verwendung in FRAMs bzw. DRAMs, Verwendung finden, nämlich Speicherzellen, die als Speicherdielektrikum 9 des Speicherkondensators 6 Dielektrika mit hoher Dielektrizitätskonstante oder Ferroelektrika aufweisen. Zur Erzeugung solcher Speicherkondensatoren 6 werden als Elektrodenmaterialien für die Elektrodenschichten 8, 10 Platin oder Platinmetalle wie Ru, Os, Rh, Ir oder Pd oder deren Oxide wie IrO₂ verwendet, um den hohen Anforderungen bei der Herstellung der Speicherkondensatoren 6 gerecht zu werden. Als Speicherdielektrika 9 können z.B. SBT SrBi₂Ta₂O₉, SBTN SrBi₂(Ta₁₋ₓNbₓ)₂O₉, PZT PbₓZr₁₋ₓTiO₃ oder BST BaₓSr₁₋ₓTiO₃ Verwendung finden.
Um die Bauelemente wie beispielsweise die Speicherkondensatoren 6 auf der Isolationsschicht 3 anzuordnen, sind bislang meist komplizierte Abscheidungs- und Abtragungsprozesse weiterer Materialschichten oder Hilfsschichten auf der Oberfläche der Isolationsschicht 3 nötig. Diese Prozesse sind mit einem nicht unerheblichen technischen Aufwand verbunden, gerade auch bei der Verwendung von Platin oder Platinmetallen als Elektrodenmaterialien.
Hier kann die vorliegende Erfindung genutzt werden, um die Erzeugung von Bauelementen für Speicherzellen zu vereinfachen.
Zur Erzeugung einer Speicheranordnung wird zunächst eine Struktur mit Auswahltransistoren 1 auf einem Halbleiterkörper 2 erzeugt, die von einer Isolationsschicht 3, z.B. aus SiO₂, bedeckt wird. Im folgenden wird eine Strukturierung der Isolationsschicht vorgenommen, wobei ein reaktives Ätzen mit CF₄ erfolgt. Es werden zunächst die Kontaktlöcher für die leitenden Plug-Verbindungen 5 zwischen den Transistoren 1 und den Speicherkondensatoren 6 in die Isolationsschicht 3 geätzt und mit Plugmaterial aufgefüllt sowie gegebenenfalls eine Barrierenschicht 7 darüber abgeschieden. Plugmaterial 5 und gegebenenfalls Barrierenschicht 7 sollen bevorzugt planar mit der Oberfläche der Isolationsschicht 3 abschließen. Es kann jedoch auch vorgesehen werden, daß das Plugmaterial 5 planar mit der Oberfläche der Isolationsschicht 3 abschließt, dann die Strukturierung der Isolationsschicht 3 wie nachfolgend beschrieben erfolgt und die Barrierenschicht 7 erst auf die bereits strukturierte Isolationsschicht 3 aufgebracht wird, d.h. sie würde in diesem Fall unter der in Fig. 4 dargestellten Elektrodenschicht 8 liegen.
Soweit im Rahmen des Strukturierungsprozesses keine optimale Steilheit der Seitenflanken der erhöhten Bereiche 4 erzielt werden kann, kann vorgesehen werden, daß nach der Abscheidung der Isolationsschicht 3 noch eine Hilfsschicht 14 auf dieser Isolationsschicht 3 abgeschieden wird, idealerweise aus einem Material, das durch chemische Veränderung in das Material der Isolationsschicht umgewandelt werden kann. Für den Fall einer Isolationsschicht aus SiO₂ bietet sich dabei eine Hilfsschicht 14 aus Polysilizium an. Es werden dann diese beiden Schichten strukturiert, so daß die erhöhten Bereiche 4 durch die Isolationsschicht 3 mit darauf angebrachter Hilfsschicht 14 gebildet werden. Anschließend erfolgt eine chemische Veränderung der Hilfsschicht 14, im speziellen Beispiel eine Oxidation, wobei diese eine Volumenausdehnung erfährt. Die Hilfsschicht bildet in diesem Beispielsfall nach der Oxidation eine stoffliche Einheit mit der Isolationsschicht, so daß für die weiteren Prozesse keine störenden Einflüsse durch diese Schicht entstehen. Somit ragt nun der Bereich der Isolationsschicht 3, der der oxidierten Hilfsschicht 14 entspricht, über die Seitenflanken der erhöhten Bereiche 4 hinaus und bewirkt eine Abschattung dieser Seitenflanken, so daß im folgenden eine Bedeckung der Seitenflanken bei der Abscheidung der Elektrodenschicht 8 optimal vermieden werden kann.
Alternativ kann auch eine Hilfsschicht 20 mit einem Ätzverhalten gewählt werden, das sich vom Ätzverhalten der Isolationsschicht 3 unterscheidet. Figuren 10 bis 12 zeigen die Verfahrensschritte für diesen speziellen Fall. Es erfolgt zunächst eine Ätzung der Isolationsschicht 3 zusammen mit der Hilfsschicht 20 zur Bildung von erhöhten Bereichen 4. Dann erfolgt ein selektives isotropes Ätzen der Isolationsschicht 3, wobei die Hilfsschicht 20 weitgehend unbeeinflußt bleibt. Nach diesem Schritt ragt die Hilfsschicht 20 über die Seitenflanken der erhöhten Bereiche 4 hinaus, so daß wiederum eine Abschattung erzielt werden kann. Erfolgt nun ein weitgehend kollimierter Auftrag einer weiteren Materialschicht 8, die noch zu einer teilweisen Kantenbedeckung führt, so werden nur die Seitenflanken der Hilfsschicht 20 bedeckt. Solche Bedeckungen können sogar erwünscht sein, da bei einem Auftrag einer Elektrodenschicht 8 nun auch die Seitenflanken der Hilfsschicht 20 als Elektrodenfläche genutzt werden können und trotzdem eine Trennung der erhöhten Bereiche 4 voneinander erzielt werden kann. Als Materialien für die Hilfsschicht 20 können dabei beispielsweise Si₃N₄ oder Polysilizium verwendet werden.

Im folgenden soll jedoch von einer Anordnung gemäß Fig. 2 ausgegangen werden, bei der eine Barrierenschicht 7 vor Strukturierung der Isolationsschicht 7 auf das Plugmaterial 5 aufgebracht wird und keine Hilfsschicht 14 vorgesehen ist. Die Isolationsschicht 3 wird nun derart strukturiert, daß erhöhte Bereiche 4 herausgebildet werden. Es sollen auf diesen Bereichen die späteren Speicherkondensatoren 6 erzeugt werden. Weitere Bauelemente sollen hier zunächst nicht betrachtet werden. Die Höhe dieser Bereiche 4 über der restlichen Oberfläche ist so zu wählen, daß sie zumindest größer ist als die Dicke der späteren unteren Elektrode 8 des Kondensators, alternativ auch höher als die gesamte Dicke des späteren Kondensators 6. Bevorzugt beträgt die Höhe der Bereiche das 2 bis 5-fache der Dicke der unteren Elektrode 8. Es kann zusätzlich noch eine Photoresistmaske aufgebracht werden, um eine zusätzliche Strukturierung der weiteren Materialschichten 8, 9, 10 wie eine Abdeckung von Dekoderbereichen und eine Trennung von einzelnen Zellfeldern zu erzielen. Es können die erhöhten Bereiche 4 wie in den Figuren dargestellt als Stege ausgebildet werden, die durch relativ breite abgesenkte Gebiete voneinander getrennt sind. Es kann jedoch auch eine Trennung erhöhter Bereiche 4 durch Strukturierung relativ schmaler Gräben erfolgen.
Durch eine Strukturierung der Oberfläche der Isolationsschicht 3 kann bereits die gesamte Struktur der auf der Isolationsschicht 3 anzuordnenden Bauelemente festgelegt werden. Die Isolationsschicht 3 ist dabei in der Regel wesentlich einfacher zu strukturieren als die weiteren Materialschichten 8, 9, 10, weshalb die erfindungsgemäße Lösung eine wesentliche Vereinfachung darstellt. Werden auf einer derart strukturierte Oberfläche die weiteren notwendigen Materialschichten 8, 9, 10 abgeschieden, so ergeben sich automatisch die gewünschten Schichtstrukturen, die als Bauelemente verwendet werden können.

Anschließend erfolgt die schichtweise Abscheidung der weiteren Materialschichten 8, 9, 10, wobei zumindest die erste Schicht 8, die als untere Kondensatorelektrode dient und aus Platin oder Platinmetall gewählt wird, durch kollimiertes Sputtern erzeugt wird. Es kann jedoch für die Elektrodenschichten 8, 10, insbesondere für die untere Elektrodenschicht 8, auch eine Mehrschichtstruktur aus den genannten Materialien vorgesehen werden, beispielsweise aus Pt/Ir oder Pt/IrO₂. Durch das kollimierte Sputtern wird eine Abscheidung der Materialschichten lediglich auf den in Targetrichtung ausgerichteten Oberflächenbereichen erzielt. Man erhält folglich eine Trennung der unterschiedlichen Schichtbereiche durch die Oberflächenstruktur. Die Kollimation verhindert dabei weitestgehend eine Abscheidung des Materials an den Seitenwänden der Erhebungen 4. Es werden bevorzugt Schichtdicken zwischen 50 und 400 nm für die untere Elektrodenschicht gewählt, idealerweise Schichtdicken zwischen 100 und 200 nm. Schichtdicken im Bereich von 200-400 nm sind insbesondere dann von Interesse, wenn zur Erzielung möglichst kleiner Strukturen die Erzeugung größerer Seitenflächen der unteren Kondensatorelektrode angestrebt wird, die dann ebenfalls als Kondensatorfläche genutzt werden können.
Durch einen nachfolgenden Ätzschritt, beispielsweise isotropes naßchemiches Ätzen mit Königswasser aus 3 Teilen HCl ,und einem Teil HNO3 können eventuelle unerwünschte Kantenbedeckungen durch die Elektrodenschicht 8 entfernt werden, wobei der Ätzschritt nun jedoch wesentlich kürzer und mit geringen Anforderungen an Selektivität, Kantensteilheit oder Ätzrate ausfallen kann, als dies zur Strukturierung der Elektrodenschicht 8 selbst üblicherweise der Fall ist. Es wird beispielsweise ein Ätzschritt mit Königswasser bei 70°C durchgeführt, der bei einer Pt-Elektrode einen Schichtabtrag von etwa 10 nm/min herbeiführt. Bei einer Elektrodenschichtabscheidung von ca. 100 nm Dicke mit einem kollimierten Verfahren können je nach Höhe der erhabenen Strukturgebiete noch Kantenbedeckungen bis etwa 10 % der Schichtdicke entstehen, so daß ein einminütiger Ätzschritt genügt, um eine vollständige Entfernung der Kantenbedeckungen sicherzustellen. Das relativ einfach zu handhabende isotrope Ätzverfahren kann dabei problemlos eingesetzt werden, da die übrigen, erwünschten Elektrodenschichtbereiche durch diesen Schichtabtrag nur unwesentlich beeinträchtigt werden und weiterhin ihre Funktionalität behalten.

Nach dem kollimierten Sputtern der ersten, inneren Elektrodenschicht erfolgt eine konformale Abscheidung der dielektrischen Schicht 9 und der zweiten, äußeren Elektrodenschicht 10. Dies ermöglicht die zusätzliche Nutzung von Seitenwänden der ersten Elektrodenschicht 8 als Kondensatorfläche und somit eine Erhöhung der Kapazität. Da sich die äußere Elektrodenschicht 8 über den gesamten Schichtbereich der Speicheranordnung erstreckt, ist zu einer Kontaktierung der einzelnen Speicherkondensatoren 6 keine zusätzliche Metallisierungsschicht nötig.

Alternativ wird eine kollimierte Aufbringung der dielektrischen Schicht sowie der Schicht für die obere Kondensatorelektrode 10 vorgesehen, die eine Trennung der einzelnen Kondensatoren voneinander ermöglicht, wobei dann allerdings keine Nutzung der Seitenwände der unteren Kondensatorelektrode 8 mehr möglich ist. Ebenso ist dann die im Gegensatz zu einer konformalen Schichtaufbringung verringerte seitliche Abschirmung der unteren Kondensatorelektrode 8 gegenüber den seitlich angrenzenden Bereichen zu beachten, so daß eventuell hier zusätzliche Abschirmungen nötig werden. Ein solches Abscheidungsverfahren ist vor allem bei der Verwendung dünner Materialschichten 8, 9, 10 praktikabel. Zur Kontaktierung der einzelnen Speicherkondensatoren 6 der Speicheranordnung ist in diesem Fall noch eine weitere Isolationsschicht 11 über der äußeren Elektrodenschicht 10 vorzusehen, in die Kontaktlöcher 12 zu den Kondensatorelektroden geätzt werden. Diese Isolationsschicht kann auch dazu verwendet werden, auf der gesamten Anordnung, die bisher in erhöhte und abgesenkte Bereiche strukturiert ist, wieder eine planare Oberfläche zu erzeugen. Wurden beispielsweise Gräben zur Erzeugung der erhöhten Bereiche 4 strukturiert, so kann durch eine konformale Abscheidung der Isolationsschicht 11 mit einer Schichtdicke, die mindestens die Hälfte der Breite der Gräben beträgt, ein Auffüllen der Gräben und damit eine weitgehend planare Oberfläche erzielt werden. Diese kann weitere Verfahrensschritte wie die Metallisierung erleichtern. Dieses Verfahren zur Erzeugung einer planaren Oberfläche kann prinzipiell bei jeder der vorstehend beschriebenen Ausgestaltungen der Erfindung Verwendung finden, jedoch gerade dort, wo eine Strukturierung von Gräben erfolgt ist.

Anschließend erfolgt die Auftragung einer Metallisierungsschicht 13, beispielsweise aus Aluminium, die dann in der gewünschten Weise leicht strukturiert werden kann. Die Auftragung der Isolationsschicht 11 und der Metallisierungsschicht 13 erfolgt dabei durch konformale Abscheidung. Zur Verkapselung der gesamten Anordnung erfolgt schließlichdie Auftragung einer weiteren, in den Figuren nicht dargestellten Isolationsschicht auf die gesamte Anordnung.

Um ein eventuelles Übersprechen zwischen benachbartgen Kondensatorstrukturen zu vermeiden, kann vorgesehen werden, die Bereiche der unteren Elektrodenschicht 8 auf ein definiertes Potential wie 0 V zu setzen, so daß zwischen den einzelnen Kondensatoren ein Bereich mit definiertem Potential gebildet wird.

Die vorgeschlagene Methode zur Erzeugung strukturierter Materialschichten kann darüber hinaus auch zur Kontaktierung des Halbleiterkörpers 2 benutzt werden. Diese Kontaktierung erfolgt in der Regel in der Peripherie der Speicheranordnung, d.h. außerhalb des Gebietes, in dem die Speicherzellen angeordnet sind. Es wird dabei eine Entfernung der unteren Elektrodenschicht 8 entbehrlich. Dies stellt einen besonderen Vorteil dar, da gerade die untere Elektrodenschicht 8 häufig aus einem Material besteht, das schwieriger zu strukturieren ist als die übrigen Materialschichten. Zur Kontaktierung wird, zusammen mit der Herstellung der leitenden Plug-Verbindung 5 zwischen Speicherkondensator 6 und Transistor 1 sowie der Herstellung des Speicherkondensators 6 selbst, eine analoge Anordnung erzeugt, die jedoch keinen Transistor 1 aufweist, sondern bei der eine leitende Verbindung 16 zwischen Halbleiterkörper 2 und der unteren Elektrodenschicht 8 gebildet wird. Nach Fertigstellung aller Kondensatorstrukturen wird im Bereich der Kontaktierung zum Halbleiterkörper 2 die äußere Elektrodenschicht 10 und die dielektrische Schicht 9 abgetragen. Somit kann nach Verkapselung der Anordnung ein Kontaktloch 18 zu der unteren Elektrodenschicht 8 in diesem Bereich geschaffen werden, und eine Metallisierung 15 aufgebracht werden, die den zweiten Teil der Kontaktierung zum Halbleiterkörper 2 bildet. Die Kontaktierung des Halbleiterkörpers 2 erfolgt also über die leitende Verbindung 16, eine eventuell vorhandene Barrierenschicht 7 analog zur Anordnung bei der Plug-Verbindung 5, den als Schichtinsel auf der Erhebung angeordneten Teil der unteren Elektrodenschicht 8 sowie den im Kontaktloch 18 befindlichen Teil der Metallisierung 15. Folglich wird ein Teil der unteren Elektrodenschicht 8 auf einfache Weise in die Kontaktierung integriert, anstatt diese Schicht auf aufwendige Weise zu entfernen, um ein Kontakloch durch alle Schichten bis zum Halbleiterkörper 2 zu schaffen, das dann mit einem Metall zur Kontaktierung des Halbleiterkörpers 2 gefüllt wird.

## Patentansprüche

1. Verfahren zur Erzeugung strukturierter Materialschichten (3, 8) auf einem Grundkörper (2), insbesondere einem Halbleiterkörper, mit den Schritten
- Bereitstellen einer ersten Materialschicht (3)
- Strukturieren der ersten Materialschicht (3) durch teilwei sen oder vollständigen lokalen Schichtabtrag zur Bildung erhabener (4) und vertiefter Schichtgebiete
- Aufbringen einer weiteren Materialschicht (8)
**dadurch gekennzeichnet,**
daß die strukturierte erste Materialschicht (3) als permanent verbleibende Materialschicht vorgesehen ist, und durch die Höhendifferenz an den Kanten der strukturierten ersten Materialschicht (3), die durch Übergänge von erhabenen (4) zu vertieften Schichtgebieten gebildet werden, eine Trennung einzelner Schichtgebiete der weiteren Materialschicht (8) an den Kanten erfolgt, wobei die Kanten der erhabenen Gebiete (4) als Abrißkanten der weiteren Materialschicht (8) wirken.

2. Verfahren nach Anspruch 1,
**dadurch gekennzeichnet,**
daß die Höhendifferenz zwischen erhabenen und vertieften Schichtgebieten mindestens das 2-fache der Schichtdicke der weiteren Materialschicht beträgt.

3. Verfahren nach Anspruch 1 oder 2,
**dadurch gekennzeichnet,**
daß die weitere Materialschicht (8) durch ein Auftragungsverfahren mit gerichteter Abscheidungscharakteristik auf der Oberfläche der ersten Materialschicht (3) abgeschieden wird.

4. Verfahren nach einem der Ansprüche 1 bis 3,
**dadurch gekennzeichnet,**
daß nach dem Abscheiden der weiteren Materialschicht (8) ein geeigneter Schichtabtrag der weiteren Materialschicht (8) zur Entfernung von Materialbedeckungen auf den Kanten durchgeführt wird.

5. Verfahren nach Anspruch 4,
**dadurch gekennzeichnet,**
daß nach dem Abscheiden der weiteren Materialschicht (8) der Schichtabtrag durch einen Ätzschritt zur Entfernung von Materialbedeckungen auf den Kanten erfolgt.

6. Verfahren nach einem der Ansprüche 1 bis 5,
**dadurch gekennzeichnet,**
daß auf die erste Materialschicht (3) eine Hilfsschicht (14) aufgebracht wird, die zusammen mit der ersten Materialschicht (3) strukturiert wird und die nach der Strukturierung derart chemisch verändert wird, daß eine Volumenausdehnung der Hilfsschicht (14) erzielt wird.

7. Verfahren nach einem der Ansprüche 1 bis 5,
**dadurch gekennzeichnet,**
daß auf die erste Materialschicht (3) eine Hilfsschicht (20) aufgebracht wird, deren Ätzverhalten sich von dem Ätzverhalten der ersten Materialschicht unterscheidet, wobei die Hilfsschicht (20) in einem ersten Verfahrensschritt zusammen mit der ersten Materialschicht (3) strukturiert wird und anschließend eine selektive Ätzung der ersten Materialschicht (3) erfolgt.

8. Verfahren nach einem der Ansprüche 1 bis 7,
**dadurch gekennzeichnet,**
daß die Erhebungen der ersten Materialschicht (3) die funktional aktiven Bereiche der weiteren Materialschicht (8) definieren.

9. Verfahren nach einem der Ansprüche 1 bis 8,
**dadurch gekennzeichnet,**
daß dadurch eine Abdeckung der vertieften Schichtgebiete der weiteren Materialschicht (8) erfolgt, welche durch Aufbringen der weiteren Materialschicht (8) auf vertiefte Schichtgebiete der strukturierten ersten Materialschicht (3) entstanden sind, die geeignet ist, diese Bereiche funktional zu neutralisieren.

10. Verfahren nach einen der Ansprüche 1 bis 9,
**dadurch gekennzeichnet,**
daß nach der gerichteten Abscheidung der ersten weiteren Materialschicht (8) eine konformale Auftragung einer nächsten weiteren Materialschicht (9) erfolgt.

11. Verfahren zur Herstellung von Bauelementen eines integrierten Schaltkreises,
gekennzeichnet durch die Verfahrensschritte nach einem der Ansprüche 1 bis 10.

12. Verfahren zur Herstellung einer Speicheranordnung nach einem der Ansprüche 1 bis 10, wobei
- in einen Halbleiterkörper (2) sowie eine auf den Halbleiterkörper (2) aufgebrachte Isolationsschicht (3) Auswahltransistoren (1) eingebettet werden und
- auf einer Trägerschicht (3) elektrische Bauelemente, insbesondere Speicherkondensatoren (6), angeordnet werden, indem weitere Materialschichten (8, 9, 10) zur Erzeugung der Bauelemente (6) auf der Oberfläche der Trägerschicht (3) abgeschieden werden,
**dadurch gekennzeichnet,**
daß die Strukturierung der weiteren Materialschichten (8, 9, 10) auf der Trägerschicht (3) durch eine Strukturierung der Oberfläche der Trägerschicht (3) in erhabene (4) und abgesenkte Gebiete erfolgt.

13. Verfahren zur Herstellung einer Speicheranordnung nach Anspruch 12,
**dadurch gekennzeichnet,**
daß die Erhebungen der Trägerschicht (3) Form und Lage der zu erzeugenden Bauelemente (6) der Speicheranordnung definieren.

14. Verfahren nach einem der Ansprüche 12 bis 13,
**dadurch gekennzeichnet,**
daß zur Erzeugung von Speicherkondensatoren (6) zunächst eine erste Elektrodenschicht (8) für eine erste Kondensatorelektrode der Speicherkondensatoren (6) durch ein Auftragungsverfahren mit gerichteter Abscheidungscharakteristik, insbesondere durch kollimiertes Sputtern, auf der Oberfläche der Trägerschicht (3) abgeschieden wird.

15. Verfahren nach Anspruch 14,
**dadurch gekennzeichnet,**
daß die erste Elektrodenschicht (8) als Mehrschichtstruktur abgeschieden wird.

16. Verfahren nach einem der Ansprüche 14 bis 15,
**dadurch gekennzeichnet,**
daß über der ersten Elektrodenschicht (8) ein Speicherdielektrikum (9) sowie eine zweite Elektrodenschicht (10) durch konformale Abscheidung aufgetragen werden.

17. Verfahren nach einem der Ansprüche 14 bis 15,
**dadurch gekennzeichnet,**
daß über der ersten Elektrodenschicht (8) ein Speicherdielektrikum (9) sowie eine zweite Elektrodenschicht (10) durch ein Auftragungsverfahren mit gerichteter Abscheidungscharakteristik, insbesondere durch kollimiertes Sputtern, aufgetragen werden.

18. Verfahren nach einem der Ansprüche 12 bis 17,
**dadurch gekennzeichnet,**
daß zur Strukturierung der erhabenen Gebiete (4) eine Strukturierung von Gräben als abgesenkte Gebiete erfolgt und in einem späteren Strukturierungsschritt eine konformaler Abscheidung einer Materialschicht (11) erfolgt mit einer Schichtdicke, die mindestens die Hälfte der Breite der Gräben beträgt.

19. Verfahren nach einem der Ansprüche 16 bis 18,
**dadurch gekennzeichnet,**
daß als Speicherdielektrikum (9) der Speicherkondensatoren (6) para- oder ferromagnetische Materialien oder dielektrische Materialien mit hoher Dielektrizitätskonstante verwendet werden.

20. Verfahren nach Anspruch 19,
**dadurch gekennzeichnet,**
daß als Speicherdielektrikum (9) SBT SrBi₂Ta₂O₉, SBTN SrBi₂ (Ta₁₋ₓNbₓ)₂O₉, PZT PbₓZr₁₋ₓTiO₃ oder BST BaₓSr₁₋ₓTiO₃ verwendet werden.

21. Verfahren nach einem der Ansprüche 14 bis 20,
**dadurch gekennzeichnet,**
daß als Elektrodenmaterial (8, 10) der Speicherkondensatoren (6) ein Edelmetall, insbesondere Pt oder ein Platinmetall wie Ru, Os, Rh, Ir oder Pd oder deren Oxide wie IrO₂, verwendet wird.

22. Verfahren nach einem der Ansprüche 16 bis 21,
**dadurch gekennzeichnet,**
daß eine Kontaktierung der Trägerschicht (3) dadurch erfolgt, daß
- ein erhabenes Gebiet (4) strukturiert wird, in das eine leitende Verbindung 16 zu der Trägerschicht (3) eingebracht wird
- nach der Abscheidung der weiteren Materialschichten (8, 9, 10) das Speicherdielektrikum (9) sowie die zweite Elektrodenschicht im Bereich des erhabenen Gebietes (4) entfernt werden
- eine Kontaktierung (15) des auf dem erhabenen Gebiet (4) angeordneten Bereiches der ersten Elektrodenschicht (8) erfolgt.
